# EUROPEAN PATENT APPLICATION

(11) **EP 4 450 987 A1**
(43) Date of publication of application: **23.10.2024**
(21) Application number: 23914919.8
(22) Date of filing: 25.10.2023
(51) Int. Cl.: G01R 31/36, G01R 31/382, G01R 31/371, H01M 50/569, H01M 10/052, H01M 50/107, H01M 50/152

(54) **DEVICE FOR IDENTIFYING REMAINING CAPACITY OF RECHARGEABLE BATTERY**

(30) Priority: 03.01.2023 KR 20230000721
(71) Applicant: Basmantechnology Co., Ltd., Hanam-si, Gyeonggi-do 12930 (KR)
(72) Inventor: KIM, Jae Young, Seoul 06767 (KR); CHO, Sung Woo, Seoul 04724 (KR)
(86) International application number: PCT/KR2023/016675
(87) International publication number: WO 2024/147455

(57) **Abstract**

**FIELD OF THE INVENTION**

The present invention relates to a device for checking the remaining capacity of a rechargeable battery, being characterized by comprising: a rechargeable battery comprising a lithium-ion battery and a circuit unit; and a portable terminal for displaying, storing, and managing data of the rechargeable battery stored in the storage unit of said circuit unit through an app, such as the manufacturing date, remaining battery capacity during charging, charging start time, charging completion time, number of charges, remaining battery capacity during discharging, discharging start time, discharging completion time, and number of discharges.

## Description

### FIELD OF THE INVENTION

The present invention relates to a device for checking the remaining capacity of a rechargeable battery, and more particularly, to a device capable of checking the remaining capacity of a rechargeable battery with a portable terminal.

### BACKGROUND OF THE INVENTION

Portable electronic devices usually operate using at least one DC 1.5V battery, and as their functionalities diversify, power consumption increases, leading to higher battery consumption, prompting the need to recharge the batteries for continued use.

To charge such a battery, the battery was stored in the housing of the charging device and supplied with commercial AC power or vehicle cigar power through a charging cable extending from one side of the housing, which was then converted to match the charging voltage of the battery, enabling the charging process.

Recently, a USB rechargeable battery that connects a USB terminal to a USB connection terminal to charge a lithium battery cell has been disclosed, as in Korean Patent Publication No. 10-2269644.

However, such a conventional USB rechargeable battery has a problem that it is difficult to check the remaining capacity when charging and using it.

### BRIEF DESCRIPTION OF THE INVENTION

### Technical Problem

The object of the present invention to solve the above problems is to provide a device for checking the remaining capacity of a rechargeable battery that capable of allowing users to monitor the remaining capacity of a rechargeable battery through a portable terminal application.

### Means for Solving the Problem

In order to achieve the above object, a device for checking the remaining capacity of a rechargeable battery of the present invention is characterized by comprising: a rechargeable battery comprising a lithium-ion battery and a circuit unit; and a portable terminal for displaying, storing, and managing data of said rechargeable battery stored in the storage unit of the circuit unit through an app, such as the manufacturing date, remaining battery capacity during charging, charging start time, charging completion time, number of charges, remaining battery capacity during discharging, discharging start time, discharging completion time, and number of discharges.

Said circuit unit is characterized by comprising: a power supply unit for supplying power and having a charge protection circuit function; a storage unit for storing said data; a control unit for controlling the power supply unit, storage unit, LED, and communication unit, and transmitting said data of the storage unit to the portable terminal upon request through the communication unit; an LED for indicating the charging status of said lithium-ion battery; and a communication unit for transmitting said data of the storage unit to the portable terminal.

Said rechargeable battery is characterized by comprising: a circuit unit and lithium-ion battery embedded inside a case; a cover fixedly coupled to the upper part of said case; and a circular anode (+) plate inserted and fixed to the upper surface of said cover.

Said rechargeable battery is characterized by having a circuit unit, USB c-type connection terminal and lithium-ion battery embedded inside a case; a cover fixedly coupled to the upper part of said case; a semicircular anode (+) plate inserted and fixed to one side of the upper surface of said cover; and a USB c-type connection terminal inside a hole formed through the cover on the side of said semicircular anode (+) plate.

Said USB c-type connection terminal is characterized by providing on the side of the circuit unit.

Said rechargeable battery is characterized by comprising: a circuit unit and lithium-ion battery embedded inside a case; a cover fixedly coupled to the upper part of said case; a USB a-type connection terminal fixedly coupled to the upper surface of said cover; a lid covering said USB a-type connection terminal; and a circular anode (+) plate in contact with the USB a-type connection terminal on the upper surface of said lid.

Said lid is characterized by being detachable from the case, with a magnet embedded along the circular perimeter of its lower end.

Said cover is characterized by being made of transparent or semi-transparent plastic material.

Said control unit is characterized by calculating the self-discharge rate based on the interval between the charging completion time of the storage unit and the start time of use, and transmitting it to the portable terminal through the communication unit.

Said control unit is characterized by setting an alarm when the lithium-ion battery is discharged to 20% or less and when charged to 95% or more, and transmitting this to the portable terminal through the communication unit.

### Effect of the Invention

As described above, according to the present invention, since the remaining capacity of the rechargeable battery may be checked through the portable terminal app, charging and replacement may be conveniently managed.

### DESCRIPTION OF THE DRAWINGS

FIG. 1 is a configuration diagram showing a device for checking the remaining capacity of a rechargeable battery according to the present invention.
FIG. 2 is a block diagram showing a circuit unit of the device for checking the remaining capacity of a rechargeable battery according to the present invention.
FIG. 3 is a block diagram showing the charging and discharging circuit according to the present invention.

### DETAILED DESCRIPTION OF THE INVENTION

Below, with reference to the attached drawings, embodiments of the present invention will be described in detail so that those skilled in the art may readily implement the present invention. However, the present invention may be implemented in various different forms and is not limited to the embodiments described herein.

Next, an embodiment of a device for checking the remaining capacity of a rechargeable battery according to the present invention will be described in detail.

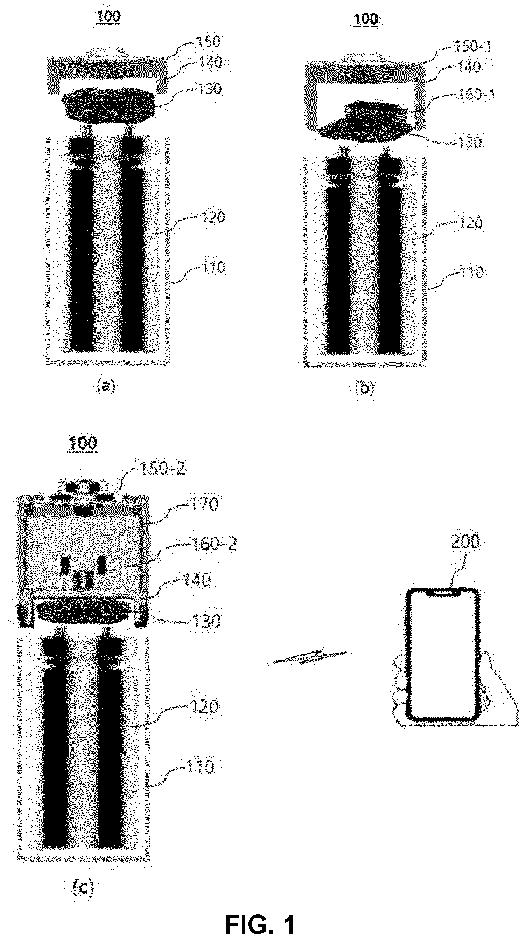

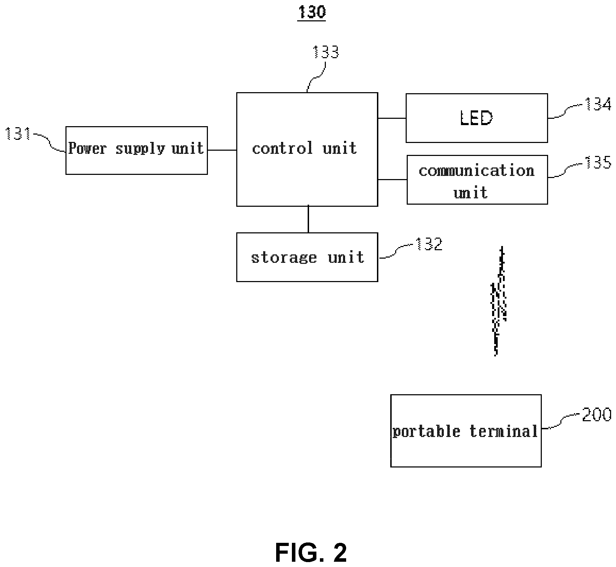

FIG. 1 is a configuration diagram showing a device for checking the remaining capacity of a rechargeable battery according to the present invention, and FIG. 2 is a block diagram showing the circuit unit of a device for checking the remaining capacity of a rechargeable battery according to the present invention.

Referring to FIGs. 1 and 2, the device for checking the remaining capacity of a rechargeable battery of the present invention may be configured to comprise a rechargeable battery 100 and a portable terminal 200.

Referring to FIG. 1(a), in said rechargeable battery 100, a circuit unit 130 and a lithium-ion battery 120 may be embedded inside a case 110. Here, said circuit unit 130 may be provided on the upper of the lithium-ion battery 120, but is not limited thereto.

A cover 140 may be fixedly coupled to the upper part of said case 110, and a circular anode (+) plate 150 may be inserted and fixed to the upper surface of said cover 140.

Referring to FIG. 1(b), in said rechargeable battery 100, the circuit unit 130, USB c-type connection terminal 160 and lithium-ion battery 120 may be embedded inside said case 110. Here, said circuit unit 130 may be provided on the upper of the lithium-ion battery 120, and the USB c-type connection terminal 160-1 is provided on the side of said circuit unit 130, but is not limited thereto.

The cover 140 may be fixedly coupled to the upper part of said case 110. Here, The semicircular anode (+) plate 150-1 may be inserted and fixed to one side of the upper surface of said cover 140, and the USB c-type connection terminal 160-1 may be provided inside a hole formed through the cover 140 on the side of said semicircular anode (+) plate 150-1.

Referring to FIG. 1(c), in said rechargeable battery 100, the circuit unit 130 and lithium-ion battery 120 may be embedded inside the case 110. Here, said circuit unit 130 may be provided on the upper of the lithium-ion battery 120, but is not limited thereto.

The cover 140 may be fixedly coupled to the upper part of said case 110, and a USB a-type connection terminal 160-2 may be fixedly coupled to the upper surface of said cover 140.

Said USB a-type connection terminal 160-2 may be covered by a lid 170, with said lid 170 being detachable from the case 110. Here, said lid 170 may have a circular anode (+) plate 150-2 formed on its upper surface that is in contact with the USB a-type connection terminal 160-2.

Meanwhile, said lid 170 may have a magnet embedded along the circular perimeter of its lower end, allowing it to be detached from the USB a-type connection terminal 160-2 and attached to the case 110 when charging. As a result, loss of the lid 170 may be fundamentally prevented.

Said cover 140 may be made of transparent or semi-transparent plastic material.

Said circuit unit 130 may be configured to comprise a power supply unit 131, a storage unit 132, a control unit 133, an LED 134, and a communication unit 135.

Said power supply unit 131 may fundamentally protect the lithium-ion battery 120 since a voltage conversion circuit is configured with 5V power supply and a charge protection circuit function.

Said storage unit 132 may store data of the rechargeable battery 100, such as the manufacturing date, remaining battery capacity during charging, charging start time, charging completion time, number of charges, remaining battery capacity during discharging, discharging start time, discharging completion time, and number of discharges.

Said control unit 133 may transmit the data of the storage unit 132 through the communication unit 135 upon request from the portable terminal 200. That is, said control unit 133 may transmit data stored in the storage unit 132 through the communication unit 135 upon request from the portable terminal 200, such as the manufacturing date, remaining battery capacity during charging, charging start time, charging completion time, number of charges, remaining battery capacity during discharging, discharging start time, discharging completion time, and number of discharges.

In addition, said control unit 133 may calculate the self-discharge rate (self-discharge time) based on the interval between the charging completion time of the storage unit 132 and the start time of use and transmit it to the portable terminal 200 through the communication unit 135.

Then, said control unit 133 may set an alarm when the lithium-ion battery 120 is discharged to 20% or less and when charged to 95% or more, and transmit it to the portable terminal 200 app through the communication unit 134. At this time, said alarm setting may be sent to the portable terminal 200.

Furthermore, said control unit 133 may control the power supply unit 131, the storage unit 132, the LED 134, and the communication unit 135.

Said LED 134 is a green LED that indicates the charging state of the lithium-ion battery, repeatedly flashing on and off for one-second intervals during charging, and remaining illuminated once charging is complete. At this time, it is possible to check the charging status through the green LED light emitted by passing through the cover 140 made of transparent or semi-transparent plastic material.

Said communication unit 135 may transmit data from the storage unit 132 to the portable terminal 200. Here, said communication unit 135 may wirelessly transmit through ZigBee, Wi-Fi, Bluetooth, etc., and preferably may wirelessly transmit through Bluetooth.

The portable terminal 200 may display, store, and manage data of the rechargeable battery 100 through an app.

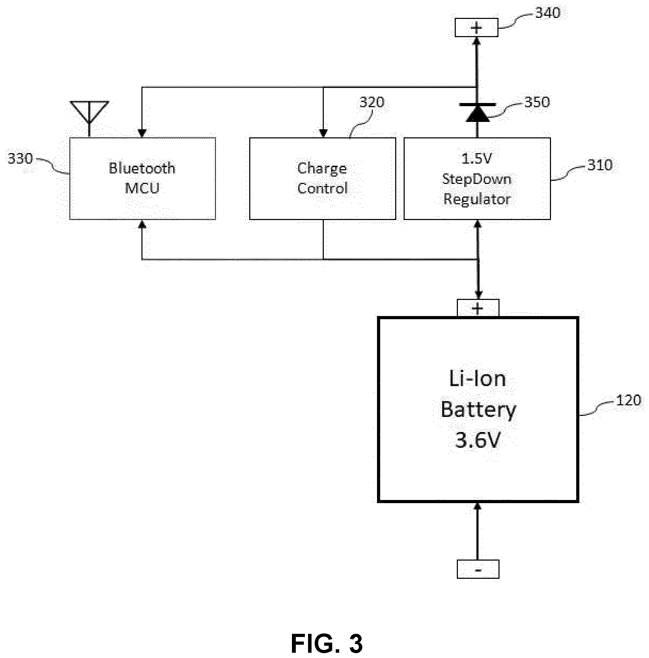

FIG. 3 is a block diagram showing the charging and discharging circuit according to the present invention.

Referring to FIG. 3, the StepDown Regulator 310 is operated for 1.5V discharging, and the Charge Control 320 may be disabled. At this time, the voltage/current output from the lithium-ion battery 120 may be detected and sent to the outside through the BLE 330 when necessary. Here, the BLE 330 may monitor the voltage to select discharge/charge.

When the voltage at the (+) terminal 340 is detected to be 4.2V, which is higher than 1.5V, the battery may be charged by enabling charge control and operating Charge Control 320. At this time, the operation of the StepDown Regulator 310 may be stopped by disabling the discharge control. Here, the StepDown Regulator 3I0 may be protected against reverse current using the Blocking Diode 350.

Although the embodiments of the present invention have been described in detail above, the scope of the present invention is not limited thereto, and various modifications and improvements by those skilled in the art using the basic concepts of the present invention, as defined in the following claims, also belong to the scope of the present invention.

## Claims

1. A device for checking the remaining capacity of a rechargeable battery, comprising:
a rechargeable battery comprising a lithium-ion battery and a circuit unit; and
a portable terminal for displaying, storing, and managing data of the rechargeable battery stored in the storage unit of the circuit unit through an app, such as the manufacturing date, remaining battery capacity during charging, charging start time, charging completion time, number of charges, remaining battery capacity during discharging, discharging start time, discharging completion time, and number of discharges;
wherein the circuit unit comprises:
a power supply unit for supplying power and having a charge protection circuit function;
a storage unit for storing the data;
a control unit for controlling the power supply unit, storage unit, LED, and communication unit, and transmitting the data of the storage unit to the portable terminal upon request through the communication unit;
an LED for indicating the charging status of the lithium-ion battery; and
a communication unit for transmitting the data of the storage unit to the portable terminal.

2. The device for checking the remaining capacity of a rechargeable battery according to claim 1, wherein the rechargeable battery comprises:
a circuit unit and lithium-ion battery embedded inside a case;
a cover fixedly coupled to the upper part of the case; and
a circular anode (+) plate inserted and fixed to the upper surface of the cover.

3. The device for checking the remaining capacity of a rechargeable battery according to claim 1, wherein the rechargeable battery has:
a circuit unit, USB c-type connection terminal and lithium-ion battery embedded inside a case;
a cover fixedly coupled to the upper part of the case;
a semicircular anode (+) plate inserted and fixed to one side of the upper surface of the cover; and
a USB c-type connection terminal inside a hole formed through the cover on the side of the semicircular anode (+) plate.

4. The device for checking the remaining capacity of a rechargeable battery according to claim 3, wherein the USB c-type connection terminal is provided on the side of the circuit unit.

5. The device for checking the remaining capacity of a rechargeable battery according to claim 1, wherein the rechargeable battery comprises:
a circuit unit and lithium-ion battery embedded inside a case;
a cover fixedly coupled to the upper part of the case;
a USB a-type connection terminal fixedly coupled to the upper surface of the cover;
a lid covering the USB a-type connection terminal; and
a circular anode (+) plate in contact with the USB a-type connection terminal on the upper surface of the lid.

6. The device for checking the remaining capacity of a rechargeable battery according to claim 5, wherein the lid is detachable from the case, with a magnet embedded along the circular perimeter of its lower end.

7. The device for checking the remaining capacity of a rechargeable battery according to any one of claims 2 to 6, wherein the cover is made of transparent or semi-transparent plastic material.

8. The device for checking the remaining capacity of a rechargeable battery according to claim 1, wherein the control unit calculates the self-discharge rate based on the interval between the charging completion time of the storage unit and the start time of use and transmits it to the portable terminal through the communication unit.

9. The device for checking the remaining capacity of a rechargeable battery according to claim 1, wherein the control unit sets an alarm when the lithium-ion battery is discharged to 20% or less and when charged to 95% or more, and transmits this to the portable terminal through the communication unit.
